# EUROPÄISCHE PATENTSCHRIFT

(11) **EP 3 345 006 B1**
(45) Veröffentlichungstag und Bekanntmachung des Hinweises auf die Patenterteilung: **15.05.2019**
(21) Anmeldenummer: 16728926.3
(22) Anmeldetag: 08.06.2016
(51) Int. Cl.: G01R 1/20, G01R 27/08, G01R 27/14

(54) **VORRICHTUNG ZUM ERFASSEN EINES WIDERSTANDSWERTES EINES MESSWIDERSTANDES EINES MESSSENSORS**
APPARATUS FOR RECORDING A RESISTANCE VALUE OF A MEASURING RESISTOR OF A MEASURING SENSOR
PROCÉDÉ DE DÉTECTION D'UNE VALEUR DE RÉSISTANCE D'UNE RÉSISTANCE DE MESURE D'UN CAPTEUR DE MESURE

(30) Priorität: 01.09.2015 DE 102015216712
(43) Veröffentlichungstag der Anmeldung: 11.07.2018
(73) Patentinhaber: Continental Automotive GmbH, 30165 Hannover (DE)
(72) Erfinder: WARNKE, Karlheinz, 93083 Obertraubling (DE); WEIGERT, Wolfgang, 93105 Tegernheim (DE)
(86) Internationale Anmeldenummer: PCT/EP2016/063036
(87) Internationale Veröffentlichungsnummer: WO 2017/036621

(56) Entgegenhaltungen:
- US-A1- 2014 191 768

## Beschreibung

### TECHNISCHES GEBIET

Die Erfindung betrifft das Gebiet der Kalibrierung von Messsensoren, insbesondere intelligenter Batteriesensoren (IBS) für Kraftfahrzeuge.

### TECHNISCHER HINTERGRUND

In modernen Kraftfahrzeugen ist eine exakte Erfassung elektrischer Messgrößen, beispielsweise elektrischer Ströme, von zunehmender Bedeutung. Zu diesem Zweck werden typischerweise Messsensoren, beispielsweise Intelligente Batteriesensoren (IBS), verbaut. Mit diesen Messsensoren kann beispielsweise der Energiebedarf elektrischer Komponenten des Kraftfahrzeug überwacht und kontrolliert werden, wodurch auch ein Beitrag zur Verbrauchsminderung und zur Reduzierung von CO2-Emissionen geleistet werden kann.

Die Erfassung elektrischer Messgrößen mittels derartiger Messsensoren erfolgt in der Regel mittels eines hochwertigen Messwiderstands bzw. Messshunts aus Manganin, welches sich vor allem durch einen sehr niedrigen Temperaturkoeffizienten auszeichnet.

Bei Verwendung von kostengünstigerem Material für den Messwiderstand bzw. Messshunt ist hingegen eine kontinuierliche Kalibrierung des Messsensors während des Betriebes erforderlich, wobei insbesondere der Widerstandswert des Messwiderstands bzw.

Messshunts von Bedeutung ist. Zur Kalibrierung des Messsensors wird typischerweise ein Kalibrierstrom eingesetzt, welcher üblicherweise mittels Vorwiderständen, Linearreglern oder Schaltreglern bereitgestellt wird. Der Kalibrierstrom wird folglich verlustbehaftet erzeugt, wodurch der Energieverbrauch des Kraftfahrzeugs nachteilig beeinflusst wird.

In der US 2014/191768 A1 ist eine Vorrichtung zur Erfassung eines Widerstandswertes eines Messwiderstandes eines Messsensors gezeigt, mit einem passiven elektrischen Schwingkreis zur Erzeugung eines vorbestimmten Kalibrierstroms.

### BESCHREIBUNG DER ERFINDUNG

Es ist daher eine Aufgabe der vorliegenden Erfindung, ein effizientes Konzept zum Erfassen eines Widerstandwertes eines Messwiderstandes eines Messsensors zu schaffen.

Diese Aufgabe wird durch die Gegenstände der unabhängigen Ansprüche gelöst. Vorteilhafte Ausführungsformen der Erfindung sind Gegenstand der abhängigen Ansprüche, der Beschreibung sowie der Figuren.

Die Erfindung beruht auf der Erkenntnis, dass ein passiver elektrischer Schwingkreis mit einem Kondensator und einer Spule eingesetzt werden kann, welcher während der Dauer einer Schwingperiode einen vorbestimmten Kalibrierstrom erzeugen kann. Die Erzeugung des vorbestimmten Kalibrierstromes erfolgt dabei sehr verlustarm, da der passive elektrische Schwingkreis überwiegend reaktive Schaltelemente aufweist. Der vorbestimmte Kalibrierstrom kann ferner hohe Stromstärken aufweisen, wodurch eine hohe Auflösung beim Erfassen des Widerstandswertes des Messwiderstands erzielt werden kann.

Ein Anschwingen bzw. Zünden des passiven elektrischen Schwingkreises kann mittels einer Steuerungseinrichtung eingeleitet werden, welche den passiven elektrischen Schwingkreis an den Messwiderstand anschalten kann, wobei der Messwiderstand mit dem vorbestimmten Kalibrierstrom beaufschlagt wird. Durch ein Erfassen einer Messspannung über dem Messwiderstand während der Schwingperiode des passiven elektrischen Schwingkreises kann folglich der Widerstandswert des Messwiderstandes effizient erfasst werden.

Um den passiven elektrischen Schwingkreis in einen definierten Zustand vor dem Anschwingen bzw. Zünden zu versetzen, kann der passive elektrische Schwingkreis ferner mit einem Energiespeicher, beispielsweise einer Gleichspannungsquelle, verbunden werden. Der passive elektrische Schwingkreis kann gegenläufig an den Messwiderstand angeschaltet und mit dem Energiespeicher verbunden werden.

Die Erfindung kann zur verlustarmen Erzeugung von Kalibrierströmen in Messsensoren, beispielsweise intelligenten Batteriesensoren (IBS), eingesetzt werden. Um eine kontinuierliche Kalibrierung der Messsensoren zu realisieren, kann der vorbestimmte Kalibrierstrom in regelmäßigen zeitlichen Abständen erzeugt und appliziert werden.

Gemäß einem ersten Aspekt betrifft die Erfindung eine Vorrichtung zum Erfassen eines Widerstandswertes eines Messwiderstandes eines Messsensors, mit einem passiven elektrischen Schwingkreis zum Erzeugen eines vorbestimmten Kalibrierstroms, wobei der passive elektrische Schwingkreis einen Kondensator umfasst, einem Energiespeicher, welcher mit dem Kondensator verbindbar ist, um den Kondensator mit elektrischer Energie zu beaufschlagen, und einer Steuerungseinrichtung, welche ausgebildet ist, den passiven elektrischen Schwingkreis an den Messwiderstand für die Dauer einer Schwingperiode des passiven elektrischen Schwingkreises anzuschalten und den Kondensator für die Dauer der Schwingperiode von dem Energiespeicher zu trennen, um den Messwiderstand mit dem vorbestimmten Kalibrierstrom zu beaufschlagen, wobei die Steuerungseinrichtung ferner ausgebildet ist, während der Dauer der Schwingperiode eine von dem vorbestimmten Kalibrierstrom abhängige Messspannung über dem Messwiderstand zu erfassen, um den Widerstandswert des Messwiderstandes zu erfassen. Dadurch wird der Vorteil erreicht, dass ein effizientes Konzept zum Erfassen eines Widerstandwertes eines Messwiderstandes eines Messsensors realisiert werden kann.

Während der Dauer einer Schwingperiode kann der passive elektrische Schwingkreis eine freie elektrische Schwingung durchführen, wobei elektrische Energie zwischen einem Kondensator und einer Spule des passiven elektrischen Schwingkreises umgeladen wird. Zur Erfassung des Widerstandswertes des Messwiderstandes können ferner mehrere aufeinanderfolgende Schwingperioden des passiven elektrischen Schwingkreises durchlaufen werden.

Der passive elektrische Schwingkreis umfasst einen Kalibrierwiderstand, wobei der Kalibrierwiderstand mit dem vorbestimmten Kalibrierstrom beaufschlagbar ist, und wobei die Steuerungseinrichtung ferner ausgebildet ist, während der Dauer der Schwingperiode eine von dem vorbestimmten Kalibrierstrom abhängige Kalibrierspannung über dem Kalibrierwiderstand zu erfassen. Dadurch wird der Vorteil erreicht, dass der vorbestimmte Kalibrierstrom innerhalb des passiven elektrischen Schwingkreises effizient bestimmt werden kann.

Der passive elektrische Schwingkreis kann den Messwiderstand umfassen. Der Messwiderstand kann ein niederohmiger Messshunt sein.

Der Kalibrierwiderstand kann einen vorbekannten Widerstandswert aufweisen. Der Kalibrierwiderstand kann ein niederohmiger Kalibriershunt sein.

Gemäß einer Ausführungsform ist die Steuerungseinrichtung ausgebildet, die Kalibrierspannung über dem Kalibrierwiderstand unter Verwendung eines Bandpass-Filters, eines Spitzenwertdetektors, und/oder einer Fourier-Transformation zu erfassen. Dadurch wird der Vorteil erreicht, dass die Kalibrierspannung effizient erfasst werden kann. Die Fourier-Transformation kann mittels einer Fast-Fourier-Transform (FFT) realisiert werden.

Gemäß einer Ausführungsform ist die Steuerungseinrichtung ausgebildet, die Messspannung über dem Messwiderstand unter Verwendung eines Bandpass-Filters, eines Spitzenwertdetektors, und/oder einer Fourier-Transformation zu erfassen. Dadurch wird der Vorteil erreicht, dass die Messspannung effizient erfasst werden kann. Die Fourier-Transformation kann mittels einer Fast-Fourier-Transform (FFT) realisiert werden.

Gemäß einer Ausführungsform ist die Steuerungseinrichtung ferner ausgebildet, nach Ablauf der Schwingperiode, insbesondere gleichzeitig, den Kondensator mit dem Energiespeicher zu verbinden und den passiven elektrischen Schwingkreis von dem Messwiderstand zu trennen. Dadurch wird der Vorteil erreicht, dass die Erzeugung des vorbestimmten Kalibrierstroms effizient unterbunden werden kann.

Gemäß einer Ausführungsform umfasst die Vorrichtung einen ersten Schalter zum Anschalten des passiven elektrischen Schwingkreises an den Messwiderstand und einen zweiten Schalter zum Verbinden des Kondensators mit dem Energiespeicher, wobei die Steuerungseinrichtung ferner ausgebildet ist, den ersten Schalter und den zweiten Schalter gegenläufig zu schalten. Dadurch wird der Vorteil erreicht, dass eine kontinuierliche und/oder zyklische Erfassung des Widerstandswertes des Messwiderstands erreicht werden kann.

Durch das gegenläufige Schalten kann ein gegenläufiges Aufladen des passiven elektrischen Schwingkreises und Erzeugen des vorbestimmten Kalibrierstroms durch den passiven elektrischen Schwingkreis realisiert werden.

Gemäß einer Ausführungsform ist der erste Schalter ein Transistor und/oder ist der zweite Schalter ein Transistor. Dadurch wird der Vorteil erreicht, dass der erste Schalter und/oder der zweite Schalter effizient implementiert werden können und ein schnelles Schalten realisiert werden kann.

Der Transistor kann ein Bipolar-Transistor, ein Metall-Oxid-Halbleiter Feldeffekt-Transistor (Metal-Oxide-Semiconductor Field-Effect-Transistor, MOSFET) oder ein Bipolar-Transistor mit isolierter Gate-Elektrode (Insulated-Gate Bipolar-Transistor, IGBT) sein.

Gemäß einer Ausführungsform ist der passive elektrische Schwingkreis ein passiver elektrischer LC-Schwingkreis zweiter Ordnung. Dadurch wird der Vorteil erreicht, dass der passive elektrische Schwingkreis effizient implementiert werden kann. Ferner kann die Dauer einer Schwingperiode des passiven elektrischen Schwingkreises effizient bestimmt werden.

Gemäß einer Ausführungsform weist der vorbestimmte Kalibrierstrom einen sinusförmigen Verlauf über der Zeit auf. Dadurch wird der Vorteil erreicht, dass ein vorbestimmter Kalibrierstrom mit hoher Stromstärke bereitgestellt werden kann. Der vorbestimmte Kalibrierstrom kann einen Kalibrierstrompuls bilden.

Gemäß einer Ausführungsform ist der Energiespeicher mit dem Messwiderstand elektrisch verbindbar. Dadurch wird der Vorteil erreicht, dass der Energiespeicher einen Betriebsstrom durch den Messwiderstand bereitstellen kann.

Gemäß einer Ausführungsform ist der Energiespeicher eine Gleichspannungsquelle, insbesondere eine Batterie. Dadurch wird der Vorteil erreicht, dass der Kondensator des passiven elektrischen Schwingkreises effizient mit elektrischer Energie beaufschlagt werden kann.

Gemäß einer Ausführungsform umfasst die Steuerungseinrichtung einen Mikro-Controller. Dadurch wird der Vorteil erreicht, dass das Anschwingen bzw. Zünden des passiven elektrischen Schwingkreises effizient eingeleitet werden kann.

Gemäß einem zweiten Aspekt betrifft die Erfindung einen Messsensor zum Erfassen einer elektrischen Messgröße, mit einem Messwiderstand, und einer Vorrichtung zum Erfassen eines Widerstandswertes des Messwiderstandes gemäß dem ersten Aspekt der Erfindung. Dadurch wird der Vorteil erreicht, dass der Messsensor effizient kalibriert werden kann.

Gemäß einer Ausführungsform ist der Messsensor ein Stromsensor zum Erfassen eines elektrischen Stroms. Dadurch wird der Vorteil erreicht, dass ein elektrischer Strom unter Verwendung des Messwiderstandes erfasst werden kann. Der zu erfassende elektrische Strom kann ein Betriebsstrom sein.

Gemäß einer Ausführungsform ist der Messsensor ein intelligenter Batteriesensor (IBS) . Dadurch wird der Vorteil erreicht, dass der Energiebedarf elektrischer Komponenten in einem Kraftfahrzeug effizient erfasst werden kann.

Gemäß einem dritten Aspekt betrifft die Erfindung ein Verfahren zum Erfassen eines Widerstandswertes eines Messwiderstandes eines Messsensors unter Verwendung eines passiven elektrischen Schwingkreises, eines Energiespeichers und einer Steuerungseinrichtung, wobei der passive elektrische Schwingkreis einen Kondensator umfasst, wobei der Energiespeicher mit dem Kondensator verbindbar ist, um den Kondensator mit elektrischer Energie zu beaufschlagen, wobei der passive elektrische Schwingkreis einen Kalibrierwiderstand umfasst, wobei der Kalibrierwiderstand mit einem vorbestimmten Kalibrierstrom beaufschlagbar ist, und wobei die Steuerungseinrichtung ferner ausgebildet ist, während der Dauer der Schwingperiode eine von dem vorbestimmten Kalibrierstrom abhängige Kalibrierspannung über dem Kalibrierwiderstand zu erfassen, mit einem Erzeugen eines vorbestimmten Kalibrierstroms durch den passiven elektrischen Schwingkreis, einem Trennen des Kondensators für die Dauer einer Schwingperiode von dem Energiespeicher durch die Steuerungseinrichtung, einem Anschalten des passiven elektrischen Schwingkreises an den Messwiderstand für die Dauer der Schwingperiode des passiven elektrischen Schwingkreises durch die Steuerungseinrichtung, um den Messwiderstand mit dem vorbestimmten Kalibrierstrom zu beaufschlagen, und einem Erfassen einer von dem vorbestimmten Kalibrierstrom abhängigen Messspannung über dem Messwiderstand während der Dauer der Schwingperiode durch die Steuerungseinrichtung, um den Widerstandswert des Messwiderstandes zu erfassen. Dadurch wird der Vorteil erreicht, dass ein effizientes Konzept zum Erfassen eines Widerstandwertes eines Messwiderstandes eines Messsensors realisiert werden kann.

Das Verfahren kann durch die Vorrichtung gemäß dem ersten Aspekt der Erfindung und/oder den Messsensor gemäß dem zweiten Aspekt der Erfindung durchgeführt werden. Weitere Merkmale des Verfahrens ergeben sich unmittelbar aus der Funktionalität der Vorrichtung und/oder des Messsensors.

Das Verfahren kann unter Verwendung eines Computerprogramms durchgeführt werden. Die Steuerungseinrichtung kann programmtechnisch eingerichtet und ausgebildet sein, das Computerprogramm auszuführen.

Die Erfindung kann in Hardware und/oder Software realisiert werden.

### BESCHREIBUNG DER FIGUREN

Weitere Ausführungsbeispiele werden bezugnehmend auf die beiliegenden Figuren näher erläutert. Es zeigen:
Fig. 1 eine schematisches Darstellung einer Vorrichtung zum Erfassen eines Widerstandswertes eines Messwiderstandes eines Messsensors;
Fig. 2 eine schematische Darstellung eines Messsensors zum Erfassen einer elektrischen Messgröße;
Fig. 3 eine schematische Darstellung eines Verfahrens zum Erfassen eines Widerstandswertes eines Messwiderstandes eines Messsensors;
Fig. 4 eine schematische Darstellung eines Messsensors zum Erfassen einer elektrischen Messgröße; und
Fig. 5 eine schematische Darstellung eines vorbestimmten Kalibrierstromes, einer Kondensatorspannung und eines Schaltzustandes eines Schalters über der Zeit.

### DETAILIERTE BESCHREIBUNG DER FIGUREN

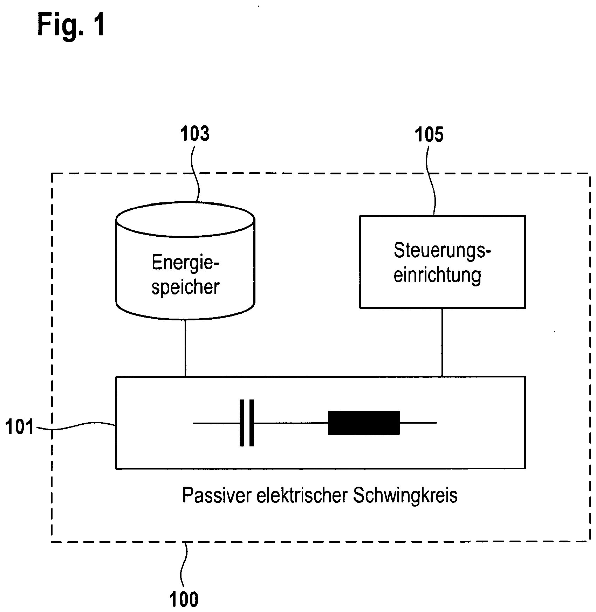

Fig. 1 zeigt eine schematische Darstellung einer Vorrichtung 100 zum Erfassen eines Widerstandswertes eines Messwiderstandes eines Messsensors gemäß einer Ausführungsform.

Die Vorrichtung 100 umfasst einen passiven elektrischen Schwingkreis 101 zum Erzeugen eines vorbestimmten Kalibrierstroms, wobei der passive elektrische Schwingkreis 101 einen Kondensator umfasst. Die Vorrichtung 100 umfasst ferner einen Energiespeicher 103, welcher mit dem Kondensator verbindbar ist, um den Kondensator mit elektrischer Energie zu beaufschlagen. Die Vorrichtung 100 umfasst zudem eine Steuerungseinrichtung 105, welche ausgebildet ist, den passiven elektrischen Schwingkreis 101 an den Messwiderstand für die Dauer einer Schwingperiode des passiven elektrischen Schwingkreises 101 anzuschalten und den Kondensator für die Dauer der Schwingperiode von dem Energiespeicher 103 zu trennen, um den Messwiderstand mit dem vorbestimmten Kalibrierstrom zu beaufschlagen, wobei die Steuerungseinrichtung 105 ferner ausgebildet ist, während der Dauer der Schwingperiode eine von dem vorbestimmten Kalibrierstrom abhängige Messspannung über dem Messwiderstand zu erfassen, um den Widerstandswert des Messwiderstandes zu erfassen.

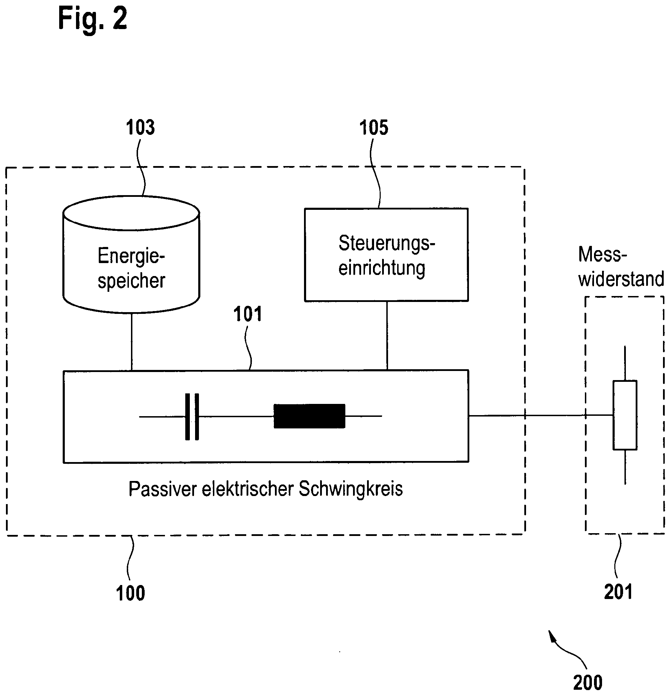

Fig. 2 zeigt eine schematische Darstellung eines Messsensors 200 zum Erfassen einer elektrischen Messgröße gemäß einer Ausführungsform.

Der Messsensor 200 umfasst einen Messwiderstand 201, und eine Vorrichtung 100 zum Erfassen eines Widerstandswertes des Messwiderstandes 201. Die Vorrichtung 100 umfasst einen passiven elektrischen Schwingkreis 101 zum Erzeugen eines vorbestimmten Kalibrierstroms, wobei der passive elektrische Schwingkreis 101 einen Kondensator umfasst. Die Vorrichtung 100 umfasst ferner einen Energiespeicher 103, welcher mit dem Kondensator verbindbar ist, um den Kondensator mit elektrischer Energie zu beaufschlagen. Die Vorrichtung 100 umfasst zudem eine Steuerungseinrichtung 105, welche ausgebildet ist, den passiven elektrischen Schwingkreis 101 an den Messwiderstand 201 für die Dauer einer Schwingperiode des passiven elektrischen Schwingkreises 101 anzuschalten und den Kondensator für die Dauer der Schwingperiode von dem Energiespeicher 103 zu trennen, um den Messwiderstand 201 mit dem vorbestimmten Kalibrierstrom zu beaufschlagen, wobei die Steuerungseinrichtung 105 ferner ausgebildet ist, während der Dauer der Schwingperiode eine von dem vorbestimmten Kalibrierstrom abhängige Messspannung über dem Messwiderstand 201 zu erfassen, um den Widerstandswert des Messwiderstandes 201 zu erfassen.

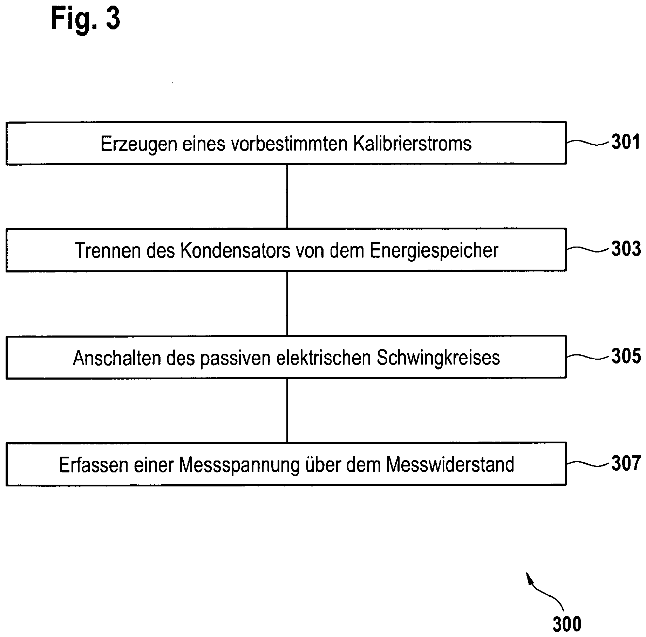

Fig. 3 zeigt eine schematische Darstellung eines Verfahrens 300 zum Erfassen eines Widerstandswertes eines Messwiderstandes eines Messsensors gemäß einer Ausführungsform.

Das Verfahren 300 wird unter Verwendung eines passiven elektrischen Schwingkreises 101, eines Energiespeichers 103 und einer Steuerungseinrichtung 105 durchgeführt, wobei der passive elektrische Schwingkreis 101 einen Kondensator umfasst, wobei der Energiespeicher 103 mit dem Kondensator verbindbar ist, um den Kondensator mit elektrischer Energie zu beaufschlagen.

Das Verfahren 300 umfasst ein Erzeugen 301 eines vorbestimmten Kalibrierstroms durch den passiven elektrischen Schwingkreis 101, ein Trennen 303 des Kondensators für die Dauer einer Schwingperiode von dem Energiespeicher 103 durch die Steuerungseinrichtung 105, ein Anschalten 305 des passiven elektrischen Schwingkreises 101 an den Messwiderstand 201 für die Dauer der Schwingperiode des passiven elektrischen Schwingkreises 101 durch die Steuerungseinrichtung 105, um den Messwiderstand 201 mit dem vorbestimmten Kalibrierstrom zu beaufschlagen, und ein Erfassen 307 einer von dem vorbestimmten Kalibrierstrom abhängigen Messspannung über dem Messwiderstand 201 während der Dauer der Schwingperiode durch die Steuerungseinrichtung 105, um den Widerstandswert des Messwiderstandes 201 zu erfassen.

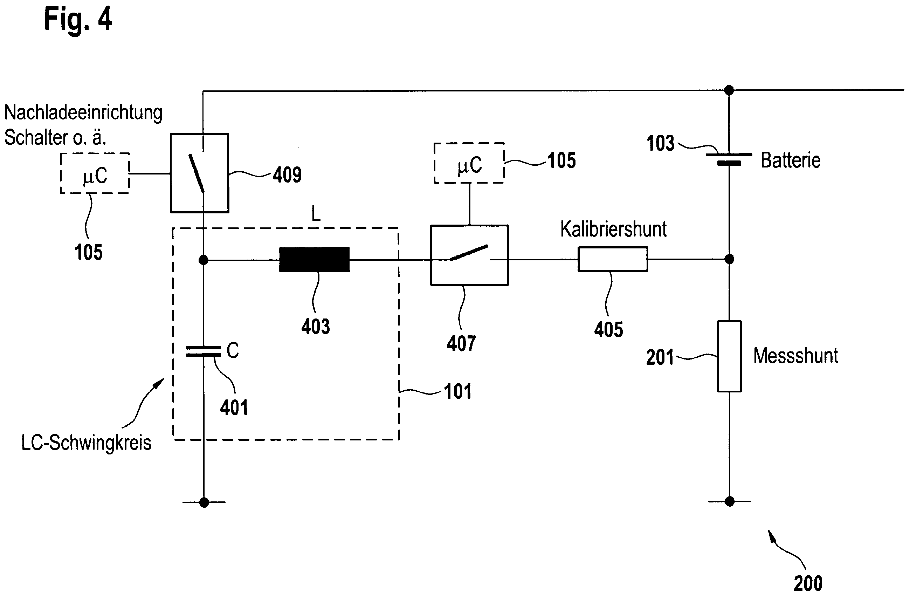

Fig. 4 zeigt eine schematische Darstellung eines Messsensors 200 zum Erfassen einer elektrischen Messgröße gemäß einer Ausführungsform.

Der Messsensor 200 umfasst einen Messwiderstand 201, und eine Vorrichtung zum Erfassen eines Widerstandswertes des Messwiderstandes 201. Der Messwiderstand 201 wird durch einen niederohmigen Messshunt gebildet.

Die Vorrichtung umfasst einen passiven elektrischen Schwingkreis 101 zum Erzeugen eines vorbestimmten Kalibrierstroms, wobei der passive elektrische Schwingkreis 101 einen Kondensator 401 mit Kapazität C und eine Spule 403 mit Induktivität L umfasst. Die Induktivität L der Spule 403 kann beispielsweise 10-20 µH betragen. Der passive elektrische Schwingkreis 101 bildet einen LC-Schwingkreis zweiter Ordnung.

Die Vorrichtung umfasst ferner einen Energiespeicher 103, welcher mit dem Kondensator 401 verbindbar ist, um den Kondensator 401 mit elektrischer Energie zu beaufschlagen. Der Energiespeicher 103 wird durch eine Gleichspannungsquelle oder Batterie gebildet.

Die Vorrichtung umfasst zudem eine Steuerungseinrichtung 105, welche ausgebildet ist, den passiven elektrischen Schwingkreis 101 an den Messwiderstand 201 für die Dauer einer Schwingperiode des passiven elektrischen Schwingkreises 101 anzuschalten und den Kondensator 401 für die Dauer der Schwingperiode von dem Energiespeicher 103 zu trennen, um den Messwiderstand 201 mit dem vorbestimmten Kalibrierstrom zu beaufschlagen, wobei die Steuerungseinrichtung 105 ferner ausgebildet ist, während der Dauer der Schwingperiode eine von dem vorbestimmten Kalibrierstrom abhängige Messspannung über dem Messwiderstand 201 zu erfassen, um den Widerstandswert des Messwiderstandes 201 zu erfassen. Die Steuerungseinrichtung 105 wird durch einen Mikro-Controller (µC) gebildet.

Der passive elektrische Schwingkreis 101 umfasst einen Kalibrierwiderstand 405, wobei der Kalibrierwiderstand 405 mit dem vorbestimmten Kalibrierstrom beaufschlagbar ist. Die Steuerungseinrichtung 105 ist ferner ausgebildet, während der Dauer der Schwingperiode eine von dem vorbestimmten Kalibrierstrom abhängige Kalibrierspannung über dem Kalibrierwiderstand 405 zu erfassen. Der Kalibrierwiderstand 405 wird durch einen niederohmigen Kalibriershunt gebildet.

Die Vorrichtung umfasst ferner einen ersten Schalter 407 zum Anschalten des passiven elektrischen Schwingkreises 101 an den Messwiderstand 201 und einen zweiten Schalter 409 zum Verbinden des Kondensators 401 mit dem Energiespeicher 103, wobei die Steuerungseinrichtung 105 ferner ausgebildet ist, den ersten Schalter 407 und den zweiten Schalter 409 gegenläufig zu schalten. Der zweite Schalter 409 kann als Nachladeeinrichtung für den Kondensator 401 dienen. Der erste Schalter 407 und der zweite Schalter 409 können jeweils durch einen Transistor, beispielsweise einen MOSFET, gebildet werden.

Die Messspannung über dem Messwiderstand 201 und/oder die Kalibrierspannung über dem Kalibrierwiderstand 405, welche jeweils einen sinusförmigen Verlauf aufweisen können, können unter Verwendung eines Bandpass-Filters, eines Spitzenwertdetektors, und/oder einer Fourier-Transformation, beispielsweise einer Fast-Fourier-Transform (FFT), effizient erfasst werden.

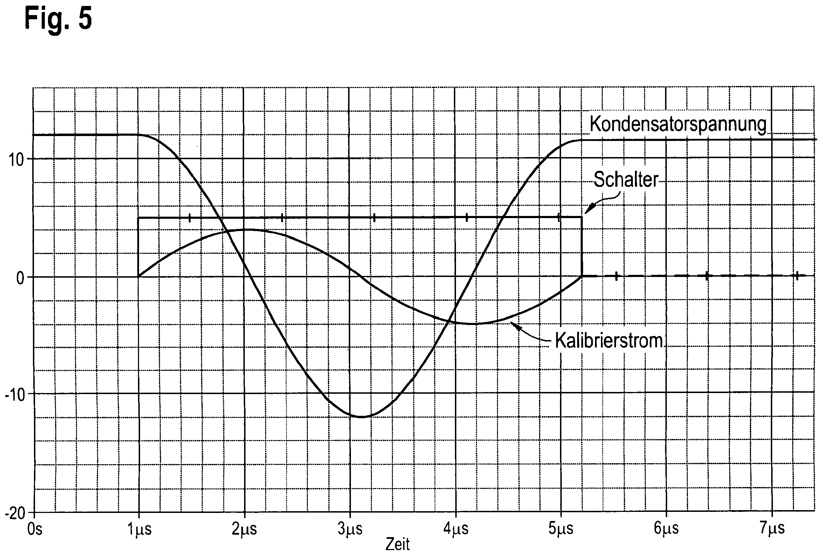

Fig. 5 zeigt eine schematische Darstellung eines vorbestimmten Kalibrierstromes, einer Kondensatorspannung und eines Schaltzustandes eines Schalters über der Zeit gemäß einer Ausführungsform.

Der vorbestimmte Kalibrierstrom weist innerhalb der Schwingperiode des passiven elektrischen Schwingkreises 101 einen sinusförmigen Verlauf über der Zeit auf. Die Kondensatorspannung über dem Kondensator 401 weist innerhalb der Schwingperiode des passiven elektrischen Schwingkreises 101 einen cosinusförmigen Verlauf über der Zeit auf. Innerhalb der Schwingperiode des passiven elektrischen Schwingkreises 101 kann der erste Schalter 407 geschlossen und der zweite Schalter 409 geöffnet sein. Die Dauer einer Schwingperiode kann beispielsweise etwa 4 µs betragen.

Das Konzept erlaubt eine Erzeugung eines Kalibrierstromes mit hoher Stromstärke, welcher einen kurzen sinusförmigen Kalibrierstrompuls bilden kann. Zur Erzeugung des vorbestimmten Kalibrierstromes kann ein passiver elektrischer Schwingkreis 101 eingesetzt werden. Der passive elektrische Schwingkreis 101 kann zyklisch für eine Schwingperiode bzw. Sinusperiode gezündet werden. Dadurch wird erreicht, dass beim Hinschwingen eine hohe Stromstärke bereitgestellt und beim Rückschwingen Energie zurückgewonnen werden kann. Aufgrund der hohen Stromstärke kann zudem eine hohe Auflösung für die Erfassung des vorbestimmten Kalibrierstromes, beispielsweise mittels des Kalibrierwiderstandes 405, erreicht werden.

Dabei wird insgesamt nur wenig Energie verbraucht, da Verluste lediglich an dem Messwiderstand 201, dem Kalibrierwiderstand 405 und designabhängig innerhalb des passiven elektrischen Schwingkreises 101 auftreten. Dadurch kann insbesondere die Gesamtenergieaufnahme des Messsensors 200 aus einem Bordnetzes eines Kraftfahrzeugs reduziert werden.

### BEZUGSZEICHENLISTE

- 100: Vorrichtung
- 101: Passiver elektrischer Schwingkreis
- 103: Energiespeicher
- 105: Steuerungseinrichtung

- 200: Messsensor
- 201: Messwiderstand

- 300: Verfahren
- 301: Erzeugen eines vorbestimmten Kalibrierstroms
- 303: Trennen des Kondensators von dem Energiespeicher
- 305: Anschalten des passiven elektrischen Schwingkreises
- 307: Erfassen einer Messspannung über dem Messwiderstand

- 401: Kondensator
- 403: Spule
- 405: Kalibrierwiderstand
- 407: Erster Schalter
- 409: Zweiter Schalter

## Patentansprüche

1. Vorrichtung (100) zum Erfassen eines Widerstandswertes eines Messwiderstandes (201) eines Messsensors (200), mit:
einem passiven elektrischen Schwingkreis (101) zum Erzeugen eines vorbestimmten Kalibrierstroms, wobei der passive elektrische Schwingkreis (101) einen Kondensator (401) umfasst, und wobei der passive elektrische Schwingkreis (101) ferner einen Kalibrierwiderstand (405) umfasst, wobei der Kalibrierwiderstand (405) mit dem vorbestimmten Kalibrierstrom beaufschlagbar ist;
einem Energiespeicher (103), welcher mit dem Kondensator (401) verbindbar ist, um den Kondensator (401) mit elektrischer Energie zu beaufschlagen; und
einer Steuerungseinrichtung (105), welche ausgebildet ist, den passiven elektrischen Schwingkreis (101) an den Messwiderstand (201) für die Dauer einer Schwingperiode des passiven elektrischen Schwingkreises (101) anzuschalten und den Kondensator (401) für die Dauer der Schwingperiode von dem Energiespeicher (103) zu trennen, um den Messwiderstand (201) mit dem vorbestimmten Kalibrierstrom zu beaufschlagen, wobei die Steuerungseinrichtung (105) ferner ausgebildet ist, während der Dauer der Schwingperiode eine von dem vorbestimmten Kalibrierstrom abhängige Messspannung über dem Messwiderstand (201) zu erfassen, um den Widerstandswert des Messwiderstandes (201) zu erfassen, und wobei die Steuerungseinrichtung (105) ferner ausgebildet ist, während der Dauer der Schwingperiode eine von dem vorbestimmten Kalibrierstrom abhängige Kalibrierspannung über dem Kalibrierwiderstand (405) zu erfassen.

2. Vorrichtung (100) nach Anspruch 1, wobei die Steuerungseinrichtung (105) ausgebildet ist, die Kalibrierspannung über dem Kalibrierwiderstand (405) unter Verwendung eines Bandpass-Filters, eines Spitzenwertdetektors, oder einer Fourier-Transformation zu erfassen.

3. Vorrichtung (100) nach einem der vorstehenden Ansprüche, wobei die Steuerungseinrichtung (105) ausgebildet ist, die Messspannung über dem Messwiderstand (201) unter Verwendung eines Bandpass-Filters, eines Spitzenwertdetektors, oder einer Fourier-Transformation zu erfassen.

4. Vorrichtung (100) nach einem der vorstehenden Ansprüche, wobei die Steuerungseinrichtung (105) ferner ausgebildet ist, nach Ablauf der Schwingperiode, insbesondere gleichzeitig, den Kondensator (401) mit dem Energiespeicher (103) zu verbinden und den passiven elektrischen Schwingkreis (101) von dem Messwiderstand (201) zu trennen.

5. Vorrichtung (100) nach einem der vorstehenden Ansprüche, mit einem ersten Schalter (407) zum Anschalten des passiven elektrischen Schwingkreises (101) an den Messwiderstand (201) und einem zweiten Schalter (409) zum Verbinden des Kondensators (401) mit dem Energiespeicher (103), wobei die Steuerungseinrichtung (105) ferner ausgebildet ist, den ersten Schalter (407) und den zweiten Schalter (409) gegenläufig zu schalten.

6. Vorrichtung (100) nach Anspruch 5, wobei der erste Schalter (407) ein Transistor ist, oder wobei der zweite Schalter (409) ein Transistor ist.

7. Vorrichtung (100) nach einem der vorstehenden Ansprüche, wobei der passive elektrische Schwingkreis (101) ein passiver elektrischer LC-Schwingkreis zweiter Ordnung ist.

8. Vorrichtung (100) nach einem der vorstehenden Ansprüche, wobei der vorbestimmte Kalibrierstrom einen sinusförmigen Verlauf über der Zeit aufweist.

9. Vorrichtung (100) nach einem der vorstehenden Ansprüche, wobei der Energiespeicher (103) mit dem Messwiderstand (201) elektrisch verbindbar ist.

10. Vorrichtung (100) nach einem der vorstehenden Ansprüche, wobei der Energiespeicher (103) eine Gleichspannungsquelle, insbesondere eine Batterie, ist.

11. Vorrichtung (100) nach einem der vorstehenden Ansprüche, wobei die Steuerungseinrichtung (105) einen Mikro-Controller umfasst.

12. Messsensor (200) zum Erfassen einer elektrischen Messgröße, mit:
einem Messwiderstand (201); und
einer Vorrichtung (100) zum Erfassen eines Widerstandswertes des Messwiderstandes (201) nach einem der Ansprüche 1 bis 11.

13. Messsensor (200) nach Anspruch 12, wobei der Messsensor (200) ein Stromsensor zum Erfassen eines elektrischen Stroms ist.

14. Verfahren (300) zum Erfassen eines Widerstandswertes eines Messwiderstandes (201) eines Messsensors (200) unter Verwendung eines passiven elektrischen Schwingkreises (101), eines Energiespeichers (103) und einer Steuerungseinrichtung (105), wobei der passive elektrische Schwingkreis (101) einen Kondensator (401) umfasst, wobei der Energiespeicher (103) mit dem Kondensator (401) verbindbar ist, um den Kondensator (401) mit elektrischer Energie zu beaufschlagen, und wobei der passive elektrische Schwingkreis (101) ferner einen Kalibrierwiderstand (405) umfasst, wobei der Kalibrierwiderstand (405) mit dem vorbestimmten Kalibrierstrom beaufschlagbar ist, und wobei die Steuerungseinrichtung (105) ferner ausgebildet ist, während der Dauer der Schwingperiode eine von dem vorbestimmten Kalibrierstrom abhängige Kalibrierspannung über dem Kalibrierwiderstand (405) zu erfassen, mit:
Erzeugen (301) eines vorbestimmten Kalibrierstroms durch den passiven elektrischen Schwingkreis (101);
Trennen (303) des Kondensators (401) für die Dauer einer Schwingperiode von dem Energiespeicher (103) durch die Steuerungseinrichtung (105);
Anschalten (305) des passiven elektrischen Schwingkreises (101) an den Messwiderstand (201) für die Dauer der Schwingperiode des passiven elektrischen Schwingkreises (101) durch die Steuerungseinrichtung (105), um den Messwiderstand (201) mit dem vorbestimmten Kalibrierstrom zu beaufschlagen; und
Erfassen (307) einer von dem vorbestimmten Kalibrierstrom abhängigen Messspannung über dem Messwiderstand (201) während der Dauer der Schwingperiode durch die Steuerungseinrichtung (105), um den Widerstandswert des Messwiderstandes (201) zu erfassen.

## Claims

1. Device (100) for recording a resistance of a measurement resistor (201) of a measurement sensor (200), having:
a passive electric oscillating circuit (101) for generating a predetermined calibration current, wherein the passive electric oscillating circuit (101) comprises a capacitor (401), and wherein the passive electric oscillating circuit (101) furthermore comprises a calibration resistor (405), wherein the predetermined calibration current is able to be applied to the calibration resistor (405);
an energy store (103) that is able to be connected to the capacitor (401) in order to apply electrical energy to the capacitor (401); and
a control apparatus (105) that is designed to switch on the passive electric oscillating circuit (101) at the measurement resistor (201) for the duration of an oscillation period of the passive electric oscillating circuit (101) and to disconnect the capacitor (401) from the energy store (103) for the duration of the oscillation period in order to apply the predetermined calibration current to the measurement resistor (201), wherein the control apparatus (105) is furthermore designed, throughout the duration of the oscillation period, to record a measurement voltage, dependent on the predetermined calibration current, across the measurement resistor (201) in order to record the resistance of the measurement resistor (201), and wherein the control apparatus (105) is furthermore designed, throughout the duration of the oscillation period, to record a calibration voltage, dependent on the predetermined calibration current, across the calibration resistor (405).

2. Device (100) according to Claim 1, wherein the control apparatus (105) is designed to record the calibration voltage across the calibration resistor (405) using a bandpass filter, a peak value detector or a Fourier transform.

3. Device (100) according to either of the preceding claims, wherein the control apparatus (105) is designed to record the measurement voltage across the measurement resistor (201) using a bandpass filter, a peak value detector or a Fourier transform.

4. Device (100) according to one of the preceding claims, wherein the control apparatus (105) is furthermore designed, after the oscillation period, in particular at the same time, to connect the capacitor (401) to the energy store (103) and to disconnect the passive electric oscillating circuit (101) from the measurement resistor (201) .

5. Device (100) according to one of the preceding claims, having a first switch (407) for switching on the passive electric oscillating circuit (101) at the measurement resistor (201) and a second switch (409) for connecting the capacitor (401) to the energy store (103), wherein the control apparatus (105) is furthermore designed to switch the first switch (407) and the second switch (409) in an opposing manner.

6. Device (100) according to Claim 5, wherein the first switch (407) is a transistor, or wherein the second switch (409) is a transistor.

7. Device (100) according to one of the preceding claims, wherein the passive electric oscillating circuit (101) is a second-order passive electric LC oscillating circuit.

8. Device (100) according to one of the preceding claims, wherein the predetermined calibration current has a sinusoidal profile over time.

9. Device (100) according to one of the preceding claims, wherein the energy store (103) is able to be electrically connected to the measurement resistor (201).

10. Device (100) according to one of the preceding claims, wherein the energy store (103) is a DC voltage source, in particular a battery.

11. Device (100) according to one of the preceding claims, wherein the control apparatus (105) comprises a microcontroller.

12. Measurement sensor (200) for recording an electrical measurement variable, having:
a measurement resistor (201); and
a device (100) for recording a resistance of the measurement resistor (201) according to one of Claims 1 to 11.

13. Measurement sensor (200) according to Claim 12, wherein the measurement sensor (200) is a current sensor for recording an electric current.

14. Method (300) for recording a resistance of a measurement resistor (201) of a measurement sensor (200) using a passive electric oscillating circuit (101), an energy store (103) and a control apparatus (105), wherein the passive electric oscillating circuit (101) comprises a capacitor (401), wherein the energy store (103) is able to be connected to the capacitor (401) in order to apply electrical energy to the capacitor (401), and wherein the passive electric oscillating circuit (101) furthermore comprises a calibration resistor (405), wherein the predetermined calibration current is able to be applied to the calibration resistor (405), and wherein the control apparatus (105) is furthermore designed, throughout the duration of the oscillation period, to record a calibration voltage, dependent on the predetermined calibration current, across the calibration resistor (405), involving:
generating (301) a predetermined calibration current through the passive electric oscillating circuit (101);
disconnecting (303) the capacitor (401) from the energy store (103) for the duration of an oscillation period by way of the control apparatus (105);
switching on (305) the passive electric oscillating circuit (101) at the measurement resistor (201) for the duration of the oscillation period of the passive electric oscillating circuit (101) by way of the control apparatus (105) in order to apply the predetermined calibration current to the measurement resistor (201); and
recording (307) a measurement voltage, dependent on the predetermined calibration current, across the measurement resistor (201) throughout the duration of the oscillation period by way of the control apparatus (105) in order to record the resistance of the measurement resistor (201).

## Revendications

1. Dispositif (100) d'acquisition d'une valeur d'une résistance de mesure (201) d'un capteur de mesure (200), le dispositif comprenant :
un circuit résonant électrique passif (101) destiné à générer un courant d'étalonnage prédéterminé, le circuit résonant électrique passif (101) comprenant un condensateur (401), et le circuit résonant électrique passif (101) comprenant en outre une résistance d'étalonnage (405), le courant d'étalonnage prédéterminé pouvant être appliqué à la résistance d'étalonnage (405) ;
un accumulateur d'énergie (103) pouvant être relié au condensateur (401) pour appliquer un courant électrique au condensateur (401) ; et
un moyen de commande (105) conçu pour relier le circuit oscillant électrique passif (101) à la résistance de mesure (201) pendant la durée d'une période d'oscillation du circuit oscillant électrique passif (101) et pour séparer le condensateur (401) de l'accumulateur d'énergie (103) pendant la durée de la période d'oscillation afin d'appliquer le courant d'étalonnage prédéterminé à la résistance de mesure (201), le moyen de commande (105) étant en outre conçu pour détecter une tension de mesure, dépendant du courant d'étalonnage prédéterminé, aux bornes de la résistance de mesure (201) pendant la durée de la période d'oscillation afin d'acquérir la valeur de la résistance de mesure (201), et le moyen de commande (105) étant en outre conçu pour détecter une tension d'étalonnage, dépendant du courant d'étalonnage prédéterminé, aux bornes de la résistance d'étalonnage (405) pendant la durée de la période d'oscillation.

2. Dispositif (100) selon la revendication 1, le moyen de commande (105) étant conçu pour détecter la tension d'étalonnage aux bornes de la résistance d'étalonnage (405) en utilisant un filtre passe-bande, un détecteur de crête ou une transformation de Fourier.

3. Dispositif (100) selon l'une des revendications précédentes, le moyen de commande (105) étant adapté pour détecter la tension de mesure aux bornes de la résistance de mesure (201) en utilisant un filtre passe-bande, un détecteur de crête ou une transformation de Fourier.

4. Dispositif (100) selon l'une des revendications précédentes, le moyen de commande (105) étant en outre conçu pour relier, à l'expiration de la période d'oscillation, en particulier simultanément, le condensateur (401) à l'accumulateur d'énergie (103) et pour séparer le circuit résonant électrique passif (101) de la résistance de mesure (201).

5. Dispositif (100) selon l'une des revendications précédentes, comprenant un premier commutateur (407) destiné à connecter le circuit oscillant électrique passif (101) à la résistance de mesure (201) et un deuxième commutateur (409) destiné connecter le condensateur (401) à l'accumulateur d'énergie (103), le moyen de commande (105) étant en outre conçu pour contre connecter le premier commutateur (407) et le deuxième commutateur (409) de manière à fonctionner en opposition.

6. Dispositif (100) selon la revendication 5, le premier commutateur (407) étant un transistor, ou le deuxième commutateur (409) étant un transistor.

7. Dispositif (100) selon l'une des revendications précédentes, le circuit résonant électrique passif (101) étant un circuit résonant LC électrique passif du deuxième ordre.

8. Dispositif (100) selon l'une des revendications précédentes, le courant d'étalonnage prédéterminé ayant un profil sinusoïdal dans le temps.

9. Dispositif (100) selon l'une des revendications précédentes, l'accumulateur d'énergie (103) pouvant être relié électriquement à la résistance de mesure (201) .

10. Dispositif (100) selon l'une des revendications précédentes, l'accumulateur d'énergie (103) étant une source de tension continue, en particulier une batterie.

11. Dispositif (100) selon l'une des revendications précédentes, le moyen de commande (105) comprenant un microcontrôleur.

12. Capteur de mesure (200), destiné à acquérir une grandeur de mesure électrique, comprenant :
une résistance de mesure (201) ; et
un dispositif (100) destiné à acquérir une valeur de la résistance de mesure (201) selon l'une des revendications 1 à 11.

13. Capteur de mesure (200) selon la revendication 12, le capteur de mesure (200) étant un capteur de courant destiné à détecter un courant électrique.

14. Procédé (300) d'acquisition d'une valeur d'une résistance de mesure (201) d'un capteur de mesure (200) à l'aide d'un circuit oscillant électrique passif (101), d'un accumulateur d'énergie (103) et d'un moyen de commande (105), le circuit résonant électrique passif (101) comprenant un condensateur (401), l'accumulateur d'énergie (103) pouvant être relié au condensateur (401) pour appliquer de l'énergie électrique au condensateur (401), et le circuit résonant électrique passif (101) comprenant en outre une résistance d'étalonnage (405), le courant d'étalonnage prédéterminé pouvant être appliqué à la résistance d'étalonnage (405), et le moyen de commande (105) étant en outre conçu pour détecter une tension d'étalonnage, dépendant du courant d'étalonnage prédéterminé, aux bornes de la résistance d'étalonnage (405) pendant la durée de la période d'oscillation, le procédé comprenant les opérations suivantes :
générer (301) un courant d'étalonnage prédéterminé à travers le circuit résonant électrique passif (101) ;
séparer (303) le condensateur (401) de l'accumulateur d'énergie (103) à l'aide du moyen de commande (105) pendant la durée d'une période d'oscillation ;
relier (305) le circuit oscillant électrique passif (101) à la résistance de mesure (201) pendant la durée de la période d'oscillation du circuit oscillant électrique passif (101) à l'aide du moyen de commande (105) pour appliquer le courant d'étalonnage prédéterminé à la résistance de mesure (201) ; et
détecter (307) une tension de mesure, dépendant du courant d'étalonnage prédéterminé, aux bornes de la résistance de mesure (201) à l'aide du moyen de commande (105) pendant la durée de la période d'oscillation afin d'acquérir la valeur de la résistance de mesure (201).
